# EUROPÄISCHE PATENTANMELDUNG

(11) **EP 4 647 794 A1**
(43) Veröffentlichungstag der Anmeldung: **12.11.2025**
(21) Anmeldenummer: 24174548.8
(22) Anmeldetag: 07.05.2024
(51) Int. Cl.: G01R 33/28, G01R 33/24, G01R 33/02, G01R 33/10, G01R 33/30, G01R 33/44, G01R 33/54

(54) **VERFAHREN UND SYSTEM ZUR BEREITSTELLUNG EINER POSITIONSINFORMATION EINES OBJEKTS IN EINEM MAGNETISCHEN STREUFELD**

(71) Anmelder: Siemens Healthineers AG, 91301 Forchheim (DE)
(72) Erfinder: Sukkau, Johann, 91074 Herzogenaurach (DE)
(74) Vertreter: Siemens Healthineers Patent Attorneys

(57) **Zusammenfassung**

Die Erfindung betrifft ein Verfahren zur Bereitstellung einer Positionsinformation eines Objekts (120) mit einem dreidimensionalen Magnetfeldstärkensensor (125, 126) im Umfeld einer ein magnetisches Streufeld erzeugenden Vorrichtung (100), umfassend: Bereitstellen (40) von B0-Referenzdaten des magnetischen Streufelds zumindest entlang einer erster Raumrichtung, wobei die erste Raumrichtung orthogonal zu einer zweiten Raumrichtung und einer dritten Raumrichtung vorgesehen ist, und wobei die B0-Referenzdaten entlang der ersten Raumrichtung an einer vordefinierten Position in der zweiten Raumrichtung und der dritten Raumrichtung bereitgestellt wird; Anordnen (41) des Magnetfeldstärkensensors (125, 126) des Objekts (120) an der vordefinierten Position; Bereitstellen (42) eines Messwerts des Magnetfeldstärkensensors (125, 126) an der vordefinierten Position; Bereitstellen (43) einer Positionsinformation des Objekts (120) in der ersten Raumrichtung basierend auf den B0-Referenzdaten und dem Messwert.

## Beschreibung

Die vorliegende Erfindung betrifft ein Verfahren und ein System zur Bereitstellung einer Positionsinformation eines Objekts mit einem dreidimensionalen Magnetfeldstärkensensor im Umfeld einer ein magnetisches Streufeld erzeugenden Vorrichtung.

Bei einer ein magnetisches Streufeld erzeugenden Vorrichtung kann es sich insbesondere um einen Magnetresonanztomographen (MRT) handeln. Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt.

Üblicherweise basiert die Ortskodierung auf einem X-Y-Z-Koordinatensystem. Dabei ist die Z-Koordinatenachse üblicherweise definiert als eine Symmetrieachse eines B0-Feldmagneten des Magnetresonanztomographen durch einen Patiententunnel des B0-Feldmagneten in Vorzugsrichtung des B0-Feldes. Die Z-Koordinatenachse ist bei der üblichen Aufstellung eines Magnetresonanztomographen horizontal ausgerichtet und verläuft zentral durch die Öffnung der Wicklungen des B0-Feldmagneten durch einen Aufnahmebereich des B0-Feldmagneten. Das Aufnahmeobjekt wird üblicherweise parallel zu der Z-Koordinatenachse auf einer Patientenliege in den Patiententunnel gebracht. Gemeinsam mit der Z-Koordinatenachse spannen eine X-Koordinatenachse und eine Y-Koordinatenachse einen Raum auf, wobei vorzugsweise die Koordinatenachsen zueinander orthogonal vorgesehen sind und die X-Koordinatenachse horizontal und die Y-Koordinatenachse vertikal ausgerichtet ist.

Im Umfeld eines solchen Magnetresonanztomographen kann es vielfältige Anwendungen geben, in denen eine Positionsbestimmung eines Objekts erforderlich ist. Objekte, wie Patientenliegen mit ansteuerbaren Verstell- oder Bewegungseinrichtungen, können beispielsweise basierend auf einer solchen Positionsinformation autonom angesteuert und bewegt werden. Eine mögliche Anwendung an einer solchen Patientenliege kann es beispielweise sein, die Patientenliege etwas abzusenken, damit sich ein Patient bequem auf die Liegefläche legen kann. Anschließend muss die Patentenliege wieder nach oben bewegt werden und relativ zum Patiententunnel, der auch als Bore bezeichnet wird, ausgerichtet werden. Nachdem die Patientenliege entsprechend ausgerichtet wurde, kann der Patient auf der Patientenliege in den Patiententunnel hineinbewegt werden.

Zur Ausrichtung der Patientenliege relativ zum Patiententunnel ist es beispielsweise bekannt, am Magnetresonanztomographen auf einer vordefinierten Position relativ zur Mitte des B0-Magneten ein Reflektor-Element anzubringen. Korrespondierend hierzu sind an der Patientenliege eine Lichtquelle und eine Fotodiode ebenfalls an einer vordefinierten Position angeordnet. Die Lichtquelle ist dabei derart ausgerichtet, dass die Lichtquelle Licht auf das Reflektor-Element abgeben kann, sobald beide korrespondierend zueinander ausgerichtet sind. Das durch das Reflektor-Element zurückgespiegelte Licht kann anschließend von der Fotodiode detektiert werden. Wenn die Patientenliege aus der abgesenkten Position unter dem Patiententunnel hochgefahren wird, wird die Bewegungsgeschwindigkeit der Patientenliege verringert, sobald der Anfang des Reflektor-Elements durch die Fotodiode detektiert wird. Die Patientenliege wird dann langsam weiter hochgefahren, bis die obere Kante des Reflektor-Elements detektiert wurde. Die obere Kante des Reflektor-Elements ist dabei derart angeordnet, dass die Patientenliege relativ zum Patiententunnel bzw. zum BO-Magneten ausgerichtet ist und die Patientenliege in den Patiententunnel eingefahren werden kann. Diese Vorgehensweise benötigt vergleichsweise viel Zeit, da die Patientenliege ab der Detektion des Reflektor-Elements langsam nach oben bewegt werden muss, um die obere Kante des Reflektor-Elements zuverlässig detektieren zu können. Darüber hinaus nimmt die Befestigung des Reflektor-Elements bei der Installation des Magnetresonanztomographen vergleichsweise viel Zeit in Anspruch, da die Anordnung des Reflektor-Elements sehr sorgfältig vorgenommen werden muss.

In diesem Zusammenhang hat sich herausgestellt, dass ein Bedarf besteht, ein Verfahren und ein System bereitzustellen, mit dem eine Positionsinformation eines Objekts mit einem dreidimensionalen Magnetfeldstärkensensor im Umfeld einer ein magnetisches Streufeld erzeugenden Vorrichtung bereitgestellt werden kann. Insbesondere besteht ein Bedarf, eine Ausrichtung einer Patientenliege eines Magnetresonanztomographen relativ zu einem Patiententunnel bzw. zu einem BO-Magneten eines Magnetresonanztomographen zu vereinfachen.

Es ist daher eine Aufgabe der vorliegenden Erfindung ein Verfahren und ein System bereitzustellen, mit dem eine Positionsinformation eines Objekts mit einem dreidimensionalen Magnetfeldstärkensensor im Umfeld einer ein magnetisches Streufeld erzeugenden Vorrichtung bereitgestellt werden kann. Insbesondere ist es eine Aufgabe der vorliegenden Erfindung eine Ausrichtung einer Patientenliege eines Magnetresonanztomographen relativ zu einem Patiententunnel bzw. zu einem BO-Magneten Magnetresonanztomographen zu vereinfachen.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

Erfindungsgemäß wird ein Verfahren zur Bereitstellung einer Positionsinformation eines Objekts mit einem dreidimensionalen Magnetfeldstärkensensor im Umfeld einer ein magnetisches Streufeld erzeugenden Vorrichtung offenbart, wobei das Verfahren zumindest die folgenden Schritte umfasst:
Bereitstellen von BO-Referenzdaten des magnetischen Streufelds zumindest entlang einer erster Raumrichtung (DCS.Y), wobei die erste Raumrichtung (DCS.Y) orthogonal zu einer zweiten Raumrichtung (DCS.X) und einer dritten Raumrichtung (DCS.Z) vorgesehen ist, und wobei die BO-Referenzdaten entlang der ersten Raumrichtung (DCS.Y) an einer vordefinierten Position in der zweiten Raumrichtung (DCS.Z) und der dritten Raumrichtung (DCS.X) bereitgestellt wird;
Anordnen des Magnetfeldstärkensensors des Objekts an der vordefinierten Position;
Bereitstellen eines Messwerts des Magnetfeldstärkensensors an der vordefinierten Position;
Bereitstellen einer Positionsinformation des Objekts in der ersten Raumrichtung (DCS.Y) basierend auf den BO-Referenzdaten und dem Messwert.

Vorzugsweise entspricht die erste Raumrichtung der Y-Koordinatenachse, die zweite Raumrichtung der Y-Koordinatenachse und die dritte Raumrichtung der Z-Koordinatenachse. Dabei ist die Z-Koordinatenachse vorzugsweise definiert als eine Symmetrieachse des B0-Feldmagneten des Magnetresonanztomographen durch den Patiententunnel des B0-Feldmagneten in Vorzugsrichtung des B0-Feldes. Die Z-Koordinatenachse ist dabei vorzugsweise horizontal ausgerichtet und verläuft zentral durch die Öffnung der Wicklungen des B0-Feldmagneten durch den Aufnahmebereich des B0-Feldmagneten. Die Koordinatenachsen sind orthogonal zueinander vorgesehen, wobei die X-Koordinatenachse horizontal und die Y-Koordinatenachse vertikal ausgerichtet ist. Ein solches auf den B0-Feldmagneten ausgerichtetes Koordinatensystem wird in der Praxis auch als sogenanntes "Device Coordinate System" (DCS), bezeichnet.

Mit anderen Worten schlägt die vorliegende Erfindung vor, an einer vordefinierten Position in der horizontalen X-Z-Koordinatenebene BO-Referenzdaten des magnetischen Streufelds entlang der vertikalen Y-Koordinatenachse bereitzustellen. An dieser vordefinierten Position kann beispielsweise ein an einer höhenverstellbaren Patientenliege angeordneter dreidimensionaler Magnetfeldstärkensensor in der X-Z-Koordinatenebene angeordnet werden, so dass mithilfe der BO-Referenzdaten und der Messwerte des Magnetfeldstärkensensors die Position des Magnetfeldstärkensensors entlang der vertikalen Y-Koordinatenachse ermittelt werden kann. Dadurch besteht die Möglichkeit, die Position des Magnetfeldstärkensensors relativ zur Patientenaufnahme entlang der Y-Koordinatenachse zu bestimmen. Bei der bevorzugten vertikalen Ausrichtung der Y-Koordinatenachse besteht somit die Möglichkeit, die Positionsinformation des Magnetfeldstärkensensors entlang der Y-Koordinatenachse zur Ausrichtung der Patientenliege relativ zur Patientenaufnahme bzw. relativ zum BO-Magneten heranzuziehen.

Es wird somit ein Verfahren offenbart, wie mit Hilfe eines dreidimensionalen Magnetfeldstärkensensors eine vertikale Y-Koordinate einer Patientenliege aus dem B0-Feld ermittelt werden kann, wobei die Y-Koordinate unmittelbar nach dem Einschalten des Magnetfeldstärkensensors sofort ermitteln werden kann. Somit kann sich ein Patient in einer abgesenkten Position auf die Liege legen und, sobald der Patient auf der Patientenliege liegt, kann die Patientenliege wieder hochgefahren werden. Die Patientenliege kann dadurch vergleichsweise schnell wieder in die zum BO-Magneten ausgerichtete Position verfahren werden. Auch ist ein zeitlich aufwändiges Positionieren eines Reflektor-Elements und einer korrespondierenden Lichtquelle und Fotodiode bei einer Installation eines Magnetresonanztomographen nicht notwendig.

Wie bereits ausgeführt, ist das Objekt vorzugsweise eine Patientenliege, die zumindest in der ersten Raumrichtung (DCS.Y) höhenverstellbar ausgebildet ist, und wobei das magnetische Streufeld von einem Magnetresonanztomographen erzeugt wird.

Vorzugsweise ist der Magnetfeldstärkensensor an einem Eckbereich der Patientenliege angeordnet, und wobei der Magnetfeldstärkensensor vorzugsweise an einer oberen Kante der Patientenliege angeordnet ist. Durch diese bevorzugte Positionierung des zumindest einen Magnetfeldstärkensensors kann dieser in einem bevorzugten Bereich des B0-Magnetfelds angeordnet werden, an dem

Vorzugsweise ist der Magnetfeldstärkesensor eingerichtet, um eine Feldstärke von drei Komponenten des B0-Feldes in drei Richtungen zu erfassen, die einen Raum aufspannen, und der Magnetfeldstärkesensor die Magnetfeldstärke als Betrag eines durch die drei Komponenten des B0-Feldes bestimmten B0-Feldvektors ermittelt.

Vorzugsweise sind die BO-Referenzdaten entlang der ersten Raumrichtungen (DCS.Y) nur für einen vordefinierten Bereich bereitgestellt. In einem auf den B0-Feldmagneten ausgerichteten Koordinatensystem (DCS-Koordinatensystem) weist der vordefinierte Bereich vorzugsweise eine Y-Koordinatenachse (DCS.Y) zwischen -700 bis 0 mm, besonders bevorzugt zwischen - 600 bis 30 mm, ganz besonders bevorzugt zwischen -550 und 15 mm auf.

Vorzugsweise werden die BO-Referenzdaten entlang der ersten Raumrichtung (DCS.Y) in Rasterpunkten mit einer Auflösung zwischen 0,1 und 10 mm, vorzugsweise zwischen 0,5 und 2 mm, besonders bevorzugt zwischen 0,7 und 1,5 mm und ganz besonders bevorzugt mit einer Auflösung von 1 mm bereitgestellt.

Vorzugsweise werden die Streufeldinformationen zwischen zwei benachbarten Rasterpunkten durch Interpolation bereitgestellt, vorzugsweise durch eine lineare Interpolation oder eine Spline-Interpolation.

Vorzugsweise wird die Positionsinformation des Objekts in der ersten Raumrichtung (DCS.Y) durch Vergleich des Messwerts mit den BO-Referenzdaten ermittelt, wobei
die Positionsinformationen in einem ersten Bereich durch Vergleich eines Betrages der Messwertkomponenten in den drei Raumrichtungen mit den BO-Referenzdaten ermittelt wird;
die Positionsinformationen in einem zweiten Bereich durch Vergleich einer Messwertkomponente in der zweiten Raumrichtung (DCS.Z) oder durch Vergleich des Betrages der Messwertkomponenten in den drei Raumrichtungen mit den BO-Referenzdaten ermittelt wird; und
die Positionsinformationen in einem dritten Bereich durch Vergleich einer Messwertkomponente in der ersten Raumrichtung (DCS.Y) mit den BO-Referenzdaten ermittelt wird.

Vorzugsweise ist der dreidimensionale Magnetfeldstärkensensor derart am Objekt angeordnet, dass die Achsen des dreidimensionalen Magnetfeldstärkensensors kollinear zu den drei Raumrichtungen (DCS-X, DCS.Y, DCS.Z) des magnetisches Streufeld ausgerichtet sind.

Vorzugsweise umfasst das Objekt weiterhin zumindest ein Speichermittel, in dem zumindest die BO-Referenzdaten entlang der ersten Raumrichtung (DCS.Y) gespeichert werden.

Vorzugsweise umfasst das Objekt weiterhin zumindest ein Rechenmittel, dass eingerichtet ist, um die Positionsinformation des Objekts bereitzustellen.

Vorzugsweise umfasst das Verfahren weiterhin die folgenden Schritte:
Bereitstellen eines Korrekturfaktors basierend auf einer Resonanzfrequenz der das magnetische Streufeld erzeugenden Vorrichtung, vorzugsweise des Magnetresonanztomographen; und
Anpassen der BO-Referenzdaten des magnetischen Streufelds basierend auf dem Korrekturfaktor.

Vorzugsweise umfasst das Verfahren weiterhin folgenden Schritt:
Bereitstellen von Steuerdaten für eine Bewegungseinrichtung, die eingerichtet ist, zumindest ein Teil des Objekts zu bewegen, wobei die Steuerdaten auf der bereitgestellten Positionsinformation des Objekts in der ersten Raumrichtung (DCS.Y) basieren.

Weiterhin betrifft die vorliegende Erfindung ein System zur Bereitstellung einer Positionsinformation eines Objekts mit einem dreidimensionalen Magnetfeldstärkensensor im Umfeld einer ein magnetisches Streufeld erzeugenden Vorrichtung, umfassend:
eine erste Schnittstelle, eingerichtet zum Empfangen von BO-Referenzdaten des magnetischen Streufelds zumindest entlang einer erster Raumrichtung (DCS.Y), wobei die erste Raumrichtung (DCS.Y) orthogonal zu einer zweiten Raumrichtung (DCS.X) und einer dritten Raumrichtung (DCS.Z) vorgesehen ist, und wobei die BO-Referenzdaten entlang der ersten Raumrichtung (DCS.Y) an einer vordefinierten Position in der zweiten Raumrichtung (DCS.Z) und der dritten Raumrichtung (DCS.X) bereitgestellt ist;
eine zweite Schnittstelle, eingerichtet zum Empfangen eines Messwerts des Magnetfeldstärkensensors an der vordefinierten Position;
eine Rechnereinheit, die mit den Schnittstellen verbunden ist und dazu konfiguriert ist, das oben beschriebene Verfahren zur Bereitstellung einer Positionsinformation eines Objekts mit einem dreidimensionalen Magnetfeldstärkensensor im Umfeld einer ein magnetisches Streufeld erzeugenden Vorrichtung auszuführen.

Schließlich betrifft die vorliegende Erfindung eine Verwendung einer in einer ersten Raumrichtung (DCS.Y) höhenverstellbar eingerichteten Patientenliege mit zumindest einem dreidimensionalen Magnetfeldstärkensensor in einem oben beschriebenen Verfahren zur Bereitstellung einer Positionsinformation eines Objekts mit einem dreidimensionalen Magnetfeldstärkensensor im Umfeld einer ein magnetisches Streufeld erzeugenden Vorrichtung.

Alle hierin beschriebenen Ausführungsformen können miteinander kombiniert werden, soweit nicht explizit etwas anderes angegeben ist. Weitere Merkmale, Vorteile und Anwendungsmöglichkeiten der vorliegenden Erfindung ergeben sich aus der nachfolgenden Beschreibung, dem Ausführungsbeispiel und den Figuren. Darin zeigen:
- **Figur 1**: zeigt eine Draufsicht auf ein erfindungsgemäßes System zur Bereitstellung einer Positionsinformation eines Objekts mit einem dreidimensionalen Magnetfeldstärkensensor im Umfeld einer ein magnetisches Streufeld erzeugenden Vorrichtung, in Form eines Magnetresonanztomographen;
- **Figur 2**: zeigt eine Seitenansicht des in **Figur 1** gezeigten Magnetresonanztomographen;
- **Figur 3**: zeigt eine schematische Darstellung eines erfindungsgemäßen Verfahrens zur Bereitstellung einer Positionsinformation eines Objekts mit einem dreidimensionalen Magnetfeldstärkensensor im Umfeld einer ein magnetisches Streufeld erzeugenden Vorrichtung; und
- **Figur 4**: zeigt einen Verlauf von |B0|, B0.Y, BO.Z entlang einer Vertikalen an einer vordefinierten Position für einen BO-Magneten, der 1,5 Tesla erzeugt.

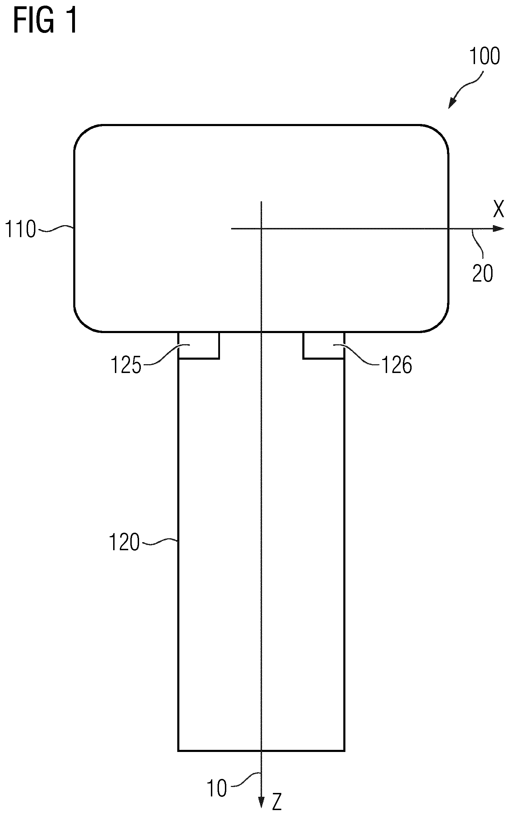

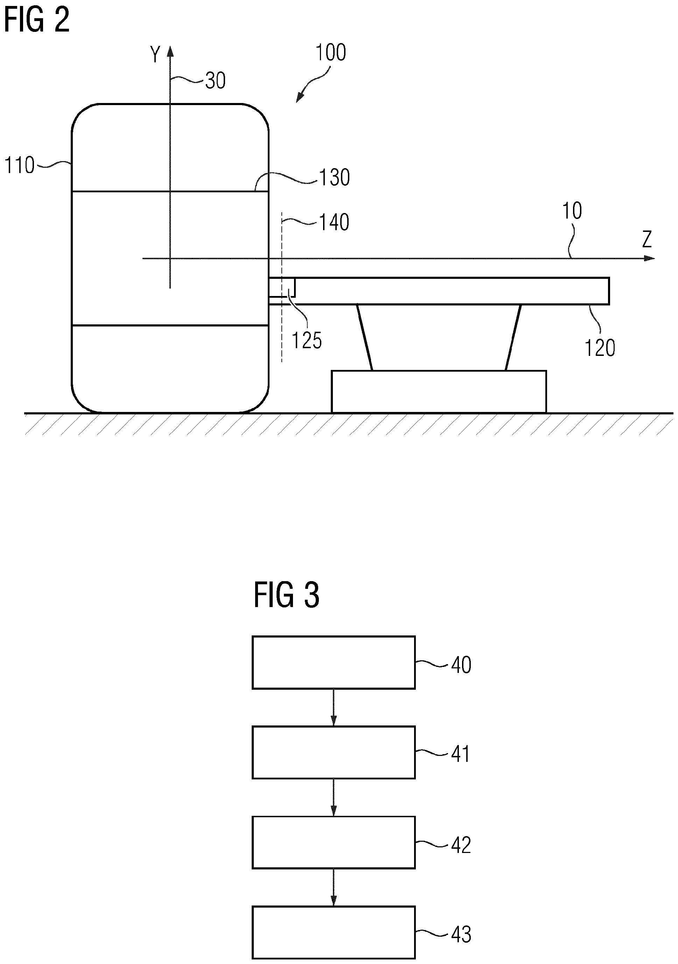

**Figur 1** zeigt eine Draufsicht und **Figur 2** eine Seitenansicht auf ein erfindungsgemäßes System 100, in Form eines Magnetresonanztomographen 100. Der Magnetresonanztomographen 100 umfasst insbesondere einen B0-Feldmagenten 110 und eine Patientenliege 120.

Wie in den **Figuren 1** **und** **2** gezeigt, basiert die Ortskodierung auf einem X-Y-Z-Koordinatensystem. Dabei ist die Z-Koordinatenachse 10 wie üblich definiert als eine Symmetrieachse des B0-Feldmagneten 110 durch einen Patiententunnel 130 des B0-Feldmagneten 100 in Vorzugsrichtung des B0-Feldes. Die Z-Koordinatenachse 10 ist bei der gezeigten, üblichen Aufstellung des Magnetresonanztomographen 100, horizontal ausgerichtet und verläuft zentral durch die Öffnung der Wicklungen des B0-Feldmagneten 110 durch den Patiententunnel 130 des B0-Feldmagneten 110. Das Aufnahmeobjekt wird üblicherweise parallel zur Z-Koordinatenachse 10 auf der Patientenliege 120 in den Patiententunnel 130 gebracht. Gemeinsam mit der Z-Koordinatenachse 10 spannen eine X-Koordinatenachse 20 und eine Y-Koordinatenachse 30 einen Raum auf, wobei die X-Y-Z-Koordinatenachsen vorzugsweise orthogonal zueinander vorgesehen sind, und wobei die X-Koordinatenachse horizontal und die Y-Koordinatenachse vertikal ausgerichtet ist.

Wie in den **Figuren 1** **und** **2** gezeigt, umfasst die Patientenliege 120 zwei dreidimensionale Magnetfeldstärkensensoren 125, 126. Die Magnetfeldstärkesensoren 125, 126 sind eingerichtet, um eine Feldstärke von drei Komponenten des B0-Feldes in drei Richtungen zu erfassen, die einen Raum aufspannen, und der Magnetfeldstärkesensor die Magnetfeldstärke als Betrag eines durch die drei Komponenten des B0-Feldes bestimmten B0-Feldvektors ermittelt. Im bevorzugten Ausführungsbeispiel sind die Achsen des dreidimensionalen Magnetfeldstärkensensors 125, 126 kollinear zu den X-Y-Z-Koordinatenachsen ausgerichtet.

Zur Durchführung des erfindungsgemäßen Verfahrens ist es grundsätzlich ausreichend, nur einen Magnetfeldstärkensensor 125, 126 vorzusehen, vorzugsweise an einer der vorderen Ecken der Patientenliege 120. Es kann allerdings auch mehr als ein Magnetfeldstärkensensor 125, 126 vorgesehen sein. Wie im bevorzugten Ausführungsbeispiel gezeigt, können beispielsweise an beiden vorderen Eckbereichen der Patientenliege 120 Magnetfeldstärkensensoren 125, 126 vorgesehen sein.

Die vorliegende Erfindung ist dabei nicht auf eine bestimmte Anzahl von Magnetfeldstärkensensoren 125, 126 beschränkt. Auch ist die vorliegende Erfindung nicht darauf beschränkt, dass die Magnetfeldstärkensensoren 125, 126 an einer bestimmten Position der Patientenliege 120 angeordnet sind. Jedoch ist es bevorzugt, dass die Magnetfeldstärkensensoren 125, 126 an den vorderen Ecken der Patientenliege 120 bzw. in den vorderen Eckbereichen der Patientenliege 120 angeordnet sind. Besonders bevorzugt ist es, dass die Magnetfeldstärkensensoren 125, 126 unmittelbar an der Liegenkante-Links und/oder an der Liegenkante-Rechts vorgesehen sind, wie dies beispielsweise in den **Figuren 1** **und** **2** gezeigt ist.

Ferner ist es bevorzugt, dass die Magnetfeldstärkensensoren 125, 126 und ggf. ein korrespondierender Mikrokontroller, der zur Verarbeitung und Auswertung der Messdaten vorgesehen sein kann, mit einem MR-verträglichen Faraday-Käfig, beispielsweise aus Carbon-Gewebe, umhüllt werden. Dadurch können störende Bildartefakte während einer Messung vermieden werden und gewährleistet werden, dass die Magnetfeldstärkensensoren 125,126 und gegebenenfalls der korrespondierende Mikrocontroller selbst nicht gestört werden. Diesbezüglich besteht auch die Möglichkeit, die Magnetfeldstärkensensoren 125, 126 während einer Messung auszuschalten. Vorzugsweise erfolgt eine Datenübertragung zum Scanner oder zu einem übergeordneten Liegenkontroller durch einen galvanischen und/oder einen optischen Übertragungsweg und/oder per Funkübertragung.

**Figur 3** zeigt eine schematische Darstellung eines Verfahrens zur Bereitstellung einer Positionsinformation eines Objekts mit einem dreidimensionalen Magnetfeldstärkensensor im Umfeld einer ein magnetisches Streufeld erzeugenden Vorrichtung.

In einem ersten Schritt 40 werden BO-Referenzdaten des magnetischen Streufelds zumindest entlang einer erster Raumrichtung bereitgestellt. Auf diese kann bei der Position- bzw. Ortsbestimmung der Magnetfeldstärkensensoren 125, 126 zurückgegriffen werden.

Durch die BO-Referenzdaten wird die Feldverteilung des B0-Magnetfelds im dreidimensionalen Raum bereitgestellt. Das bedeutet, für einen bestimmten Punkt im X-Y-Z-Koordinatensystem wird ein B0-Vektor mit den drei Parametern (B0.X, B0.Y, BO.Z) und sein Betrag |B0| bereitgestellt.

Die erste Raumrichtung ist orthogonal zu einer zweiten Raumrichtung und einer dritten Raumrichtung vorgesehen, wobei die BO-Referenzdaten entlang der ersten Raumrichtung an einer vordefinierten Position in der zweiten Raumrichtung und der dritten Raumrichtung bereitgestellt werden. Die erste Raumrichtung ist vorzugsweise parallel zur Y-Koordinatenachse vorgesehen, wobei BO-Referenzdaten vorzugsweise nur für einen Bereich bzw. eine Strecke, die zur Höhenverstellbarkeit der Patientenliege 120 korrespondiert, bereitgestellt werden. Im bevorzugten Ausführungsbeispiel sind zwei Magnetfeldstärkensensoren 125, 126 in den vorderen Eckbereichen der Patientenliege 120 vorgesehen. Korrespondierend hierzu werden BO-Referenzdaten entlang der ersten Raumrichtung an zwei vordefinierten Positionen in der X-Z Koordinatenebene bereitgestellt. In **Figur 2** ist der Bereich, der zur Höhenverstellbarkeit der Patientenliege 120 korrespondiert, mit der gestrichelten Linie 140 verdeutlicht. Vorzugsweise werden nur korrespondierend zur Höhenverstellbarkeit der Patientenliege 120 B0-Referenzdaten in der ersten Raumrichtung bereitgestellt, also nur entlang der gestrichelten Linie 140.

In einem weiteren Schritt 41 wird der Magnetfeldstärkensensors 125, 126 des Objekts 120, hier die Patientenliege 120, an der vordefinierten Position angeordnet. Mit anderen Worten wird die Patientenliege 120 derart am BO-Magneten 110 positioniert, dass die Magnetfeldstärkensensoren 125, 126 der Patientenliege 120 jeweils an der Position angeordnet sind, für die die BO-Referenzdaten in der ersten Raumrichtung bereitgestellt wurden. Wie in **Figur 2** gut zu erkennen, ist der Magnetfeldstärkensensor 125 an der gestrichelten Linie 140 positioniert. Bei einer Höhenverstellung der Patientenliege 120 bewegt sich der Magnetfeldstärkensensor 125 entlang der gestrichelten Linie 140, also parallel zur Y-Koordinatenachse, und damit entlang des Bereichs, für den die BO-Referenzdaten in der ersten Raumrichtung bereitgestellt wurden.

In einem weiteren Schritt 42 wird ein Messwert des Magnetfeldstärkensensors 125, 126 bereitgestellt. In einem weiteren Schritt 43 kann durch Vergleich des Messwerts und der B0-Referenzdaten schließlich die Höhe bzw. die Y-Koordinate des Magnetfeldstärkensensors 125, 126 in seiner jeweiligen Position an der gestrichelten Linie 140 ermittelt werden.

Mit anderen Worten schlägt die vorliegende Erfindung vor, an einer vordefinierten Position in der horizontalen X-Z-Koordinatenebene BO-Referenzdaten des magnetischen Streufelds parallel zur vertikalen Y-Koordinatenachse bereitzustellen. An dieser vordefinierten Position kann der an der höhenverstellbaren Patientenliege 120 angeordneter Magnetfeldstärkensensor 125, 126 in der X-Z-Koordinatenebene angeordnet werden, so dass mithilfe der B0-Referenzdaten und der Messwerte des Magnetfeldstärkensensors 125, 126 die Position des Magnetfeldstärkensensors 125, 126 ermittelt werden kann. Dadurch besteht die Möglichkeit, die Position des Magnetfeldstärkensensors 125, 126 relativ zur Patientenaufnahme 130 entlang der Y-Koordinatenachse zu bestimmen. Bei der bevorzugten vertikalen Ausrichtung der Y-Koordinatenachse besteht somit die Möglichkeit, die Positionsinformation des Magnetfeldstärkensensors 125, 126 entlang der Y-Koordinatenachse zur Ausrichtung der Patientenliege 120 relativ zur Patientenaufnahme 130 bzw. relativ zum BO-Magneten 110 heranzuziehen.

Nachfolgend werden besonders bevorzugte Ausgestaltungen und Aspekte des erfindungsgemäßen Verfahrens beschrieben:
Die notwendigen BO-Referenzdaten können für die vorliegende Anwendung räumlich stark eingegrenzt werden, denn BO-Referenzdaten sind nur auf einer Vertikalen vom Boden des Scanner-Raums bis maximal zur Mitte des BO-Magneten 110 erforderlich, da die Magnetfeldstärkensensoren 125, 126 aufgrund der begrenzten Höhenverstellbarkeit der Patientenliege 120 nur in diesem Bereich positioniert werden können. Werden beispielsweise BO-Referenzdaten entlang der Vertikalen mit einer 1 mm-Abtastung bereitgestellt, müssen für eine Vertikale von 1 Meter 1000 B0-Referenzwerte erfasst und bereitgestellt werden. Die X-Koordinate und die Z-Koordinate sind durch die Geometrie des B0-Magenten und der Patientenliege 120 festgelegt. In einer typischen Ausgestaltung befindet sich einer der Magnetfeldstärkensensoren 125, 126 vorne rechts an der Patientenliege 120, beispielsweise an einer X-Koordinate von 300 mm und einer Z-Koordinate von 800 mm. Der zweite Magnetfeldstärkensensor 125 befindet sich vorne links an der Patientenliege 120, beispielsweise an einer X-Koordinate -300 mm und einer Z-Koordinate von 800 mm. Die hierzu korrespondierenden vertikale Linien 140 (vgl. **Figur 2**) mit diesen Koordinaten befinden sich knapp außerhalb des BO-Magneten 110 in den Ecken der angedockten Patientenliege 120.

Diese Eingrenzung der BO-Referenzdaten auf 1000 Werte ermöglicht es, dass vorliegende Verfahren zur Ermittlung einer Y-Position/Koordinate eines Magnetfeldstärkensensors 125, 126 bzw. einer Patientenliege 120 auch auf einem weniger leistungsstarken Mikrokontroller mit vergleichsweise geringen Speichermitteln auszuführen. Die Auflösung der BO-Referenzdaten von 1 mm bedeutet dabei jedoch nicht, dass auch die Genauigkeit der Positionsbestimmung auf eine 1 mm Auflösung begrenzt wäre. Nachdem die B0-Feldverläufe stetig und glatt ausgebildet sind, können diese zwischen zwei benachbarten B0-Referenzdatenpunkten durch eine lineare Interpolation gut approximiert werden. Die bereitzustellenden BO-Referenzdaten können dabei noch weiter begrenzt werden, indem berücksichtigt wird, dass die Patientenliege 120 nicht bis zum Boden des Scanner-Raums bewegt werden können, sondern typischerweise eine unterste Stellung auf einer minimalen Höhe von etwa 57 cm vom Fußboden aufweisen. Es ist somit möglich, BO-Referenzdaten erst ab einer minimalen Höhe einer Patientenliege 120 bereitzustellen.

Um die Y-Positionsbestimmung aus den BO-Referenzdaten in möglichst optimaler Form durchzuführen, ist es bevorzugt, in unterschiedlichen Y-Koordinaten-Bereichen, die Positionsinformationen durch Vergleich unterschiedlicher Messwertkomponenten abzuleiten.

Wie ausgeführt, wird durch die BO-Referenzdaten die Feldverteilung des B0-Magnetfelds im dreidimensionalen Raum bereitgestellt. Das bedeutet, für einen bestimmten Punkt im X-Y-Z-Koordinatensystem wird ein B0-Vektor mit den drei Parametern (B0.X, B0.Y, BO.Z) und sein Betrag |B0| bereitgestellt.

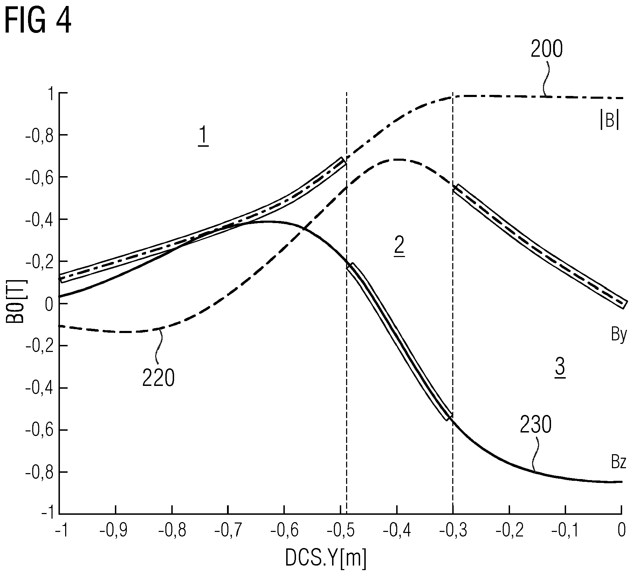

In **Figur 4** ist der Verlauf von |B0|, B0.Y, BO.Z entlang der Vertikalen 140 für einen B0-Magneten abgebildet, der 1,5 Tesla erzeugt. Die Vertikale 140 ist vorne rechts an der Patientenliege 120 vorgesehen, beispielsweise an einer X-Koordinate von 300 mm und einer Z-Koordinate von 800 mm. Die Linie 200 zeigt den Verlauf des B0-Betrags entlang der Vertikalen 140. Die Linie 210 entspricht dem Verlauf von B0.Y und die Linie 230 zeigt BO.Z entlang der Vertikalen 140.

Die hier beispielhaft angeführte Position eines Magnetfeldstärkensensors 125 in der X-Y Ebene mit den Werten X = 300 mm und Z = 800 mm, bezieht sich auf einen beispielhaft angeführten 1,6 m langen B0-Feldmagneten. Die 3 Tesla B0-Feldmagnete sind etwas länger, beispielsweise 1,9m, und die 7 Tesla B0-Feldmagnete sind noch etwas länger. Mit dieser Länge ändert sich die Z-Position korrespondierend, beispielsweise auf Z = 950 mm. Die X-Position ist abhängig vom Durchmesser des Patiententunnels 130. Die entsprechenden Koordinaten sollten derart gewählt werden, dass ein Magnetfeldstärkensensor vorteilhafterweise möglichst am linken oder rechten Rand der Patientenliege 120 angebracht wird, da dort die BO-Referenzdaten besonders vorteilhaft verlaufen. Die vorliegend Erfindung Aber ist jedoch nicht auf eine solche Anordnung beschränkt, da die vorliegende Erfindung grundsätzlich auch an beliebigen anderen X-Z-Koordinaten der Patientenliege 120 durchgeführt werden kann.

Für andere, in der Praxis häufig eingesetzten, B0-Magnete, beispielsweise mit 0,55 Tesla, 3 Tesla oder 7 Tesla, sind die Verläufe von |B0|, B0.Y, BO.Z ähnlich ausgebildet. Diese unterscheiden im Wesentlichen nur durch Skalierungsfaktoren. Die in **Figur 4** gezeigten Verläufe für |B0|, B0.Y, BO.Z können somit stellvertretend für andere B0-Magnetfelder betrachtet werden.

Wie in **Figur 4** gut zu erkennen ist, führt in den mit "1", "2" und "3" gekennzeichneten Bereichen jeweils ein anderer Vergleich des Messwerts des Magnetfeldstärkensensors 125, 126 mit |B0|, B0.Y oder BO.Z zu eindeutigen bzw. genaueren Ergebnissen für die Y-Koordinate.

Beispielsweise kann im Bereich "3", d.h. bei DCS.Y > - 0,3 m, die Bestimmung der Y-Koordinate aus |B0| nicht sehr genau durchgeführt werden, da der Verlauf von |B0| im Bereich "3" fast horizontal ist und eine Bestimmung einer Y-Koordinate aus einem durch den Magnetfeldstärkensensor 125, 126 gemessenen B0-Betrag somit keinen in Y-Richtung genau definierten/kleinen Punkt, sondern einen vergleichsweise großen Y-Bereich ergeben würde. In dem Bereich "2", d.h. bei - 0,5 m < DCS.Y < - 0,3 m, wäre eine Bestimmung einer Y-Koordinate aus dem B0-Betrag zwar grundsätzlich möglich, aber nicht optimal, wegen der immer flacher werdenden Steigung in Richtung des Bereichs "3". Der Verlauf des B0-Betrags im Bereich "1" ist hingegen optimal, da dieser dort fast linear und streng monoton steigend verläuft. Die anderen beiden Verläufe Bz und By führen im Bereich "1" ebenfalls zu keiner genauen Y-Koordinate, sondern zu einem Y-Bereich, also zu einer vergleichsweise ungenauen Y-Positionsbestimmung.

Im Bereich "2" kann die Bestimmung der Y-Koordinate sowohl aus |B|, als auch aus Bz mit hoher Genauigkeit erfolgen. Die Bestimmung aus Bz kann zu noch genaueren Y-Koordinaten führen, da im Bereich "2" die Bz-Steigung deutlich höher ist und der Verlauf von Bz streng monoton fallend und fast linear ist.

Im Bereich "3" kann die Bestimmung der Y-Koordinate mit hoher Genauigkeit aus By erfolgen, deren Verlauf dort streng monoton fallend ist.

Es ist somit bevorzugt, dass für die Y-Positionsbestimmung des Magnetfeldstärkensensors 125, 126 bzw. der Patientenliege 120:
die Y-Positionsbestimmung in einem ersten Bereich der Vertikalen 140 durch Vergleich der |B0| Referenzdaten mit der |B0| Messwertkomponenten erfolgt;
die Y-Positionsinformationen in einem zweiten Bereich der Vertikalen 140 durch Vergleich Bz Referenzdaten oder |B0| Referenzdaten mit der jeweiligen Messwertkomponenten erfolgt; und
die Y-Positionsinformationen in einem dritten Bereich der Vertikalen 140 durch Vergleich der By Referenzdaten mit der By Messwertkomponente erfolgt.

Die konkrete Berechnung einer Y-Koordinate einer der Magnetfeldstärkensensoren 125, 126 erfolgt vorzugsweise in zwei Schritten. In einem ersten Schritt werden zunächst die zwei benachbarten Werte aus den BO-Referenzdaten ermittelt, die den Messwert des Magnetfeldstärkensensors 125, 126 einschließen. In einem zweiten Schritt erfolgt eine Interpolation der zwei benachbarten Werte aus den BO-Referenzdaten, so dass die Y-Koordinate zum Messwert des Magnetfeldstärkensensors 125, 126 genauer ermittelt werden kann. Eine solche Interpolation kann als lineare Interpolation oder auch als Spline-Interpolation ausgestaltet sein.

Mit dem vorgeschlagenen Verfahren kann die Y-Koordinate bzw. die Y-Position einer Patientenliege 120 vergleichsweise genau, in der Praxis mit einer Genauigkeit von etwa 0,1mm, und vergleichsweise kostengünstig bestimmt werden. Im Gegensatz zur bisherigen Vorgehensweise sind keine zeitintensiven Ausrichtungen an einem Retroreflektor-Element mehr notwendig. Die Y-Koordinate der Patientenliege 120 kann instantan bereitgestellt werden. Auch die Installation eines Magnetresonanztomographen kann schneller erfolgen, da keine Retroreflektor-Element am BO-Magneten 110 mehr vorgesehen werden müssen, und somit auch keine zeitaufwändige Justage mehr notwendig ist.

Die vorliegende Erfindung ist nicht auf die vorhergehend beschriebene Ausführungsform beschränkt, solange sie vom Gegenstand der nachfolgenden Ansprüche umfasst ist. Ergänzend wird darauf hingewiesen, dass die Begriffe "umfassend" und "aufweisend" keine anderen Elemente oder Schritte ausschließen und die unbestimmten Artikel "eine" oder "ein" keine Vielzahl ausschließen. Ferner wird darauf hingewiesen, dass Merkmale oder Schritte, die mit Verweis auf obige Ausführungsformen beschrieben worden sind, auch in Kombination mit anderen Merkmalen verwendet werden können.

Darüber hinaus wird darauf hingewiesen, dass unabhängig vom grammatikalischen Geschlecht eines bestimmten Begriffs, Personen mit männlicher, weiblicher oder anderer Geschlechteridentität mit umfasst sind.

## Patentansprüche

1. Verfahren zur Bereitstellung einer Positionsinformation eines Objekts (120) mit einem dreidimensionalen Magnetfeldstärkensensor (125, 126) im Umfeld einer ein magnetisches Streufeld erzeugenden Vorrichtung (100), umfassend:
Bereitstellen (40) von BO-Referenzdaten des magnetischen Streufelds zumindest entlang einer erster Raumrichtung, wobei die erste Raumrichtung orthogonal zu einer zweiten Raumrichtung und einer dritten Raumrichtung vorgesehen ist, und wobei die B0-Referenzdaten entlang der ersten Raumrichtung an einer vordefinierten Position in der zweiten Raumrichtung und der dritten Raumrichtung bereitgestellt wird;
Anordnen (41) des Magnetfeldstärkensensors (125, 126) des Objekts (120) an der vordefinierten Position;
Bereitstellen (42) eines Messwerts des Magnetfeldstärkensensors (125, 126) an der vordefinierten Position;
Bereitstellen (43) einer Positionsinformation des Objekts (120) in der ersten Raumrichtung basierend auf den BO-Referenzdaten und dem Messwert.

2. Verfahren nach Anspruch 1, wobei das Objekt (120) eine Patientenliege (120) ist, die höhenverstellbar in der ersten Raumrichtung ausgebildet ist, und wobei das magnetische Streufeld von einem Magnetresonanztomographen (100) erzeugt wird.

3. Verfahren nach Anspruch 2, wobei der Magnetfeldstärkensensor (125, 126) an einem Eckbereich der Patientenliege (120) angeordnet ist, und wobei der Magnetfeldstärkensensor (125, 126) vorzugsweise an einer oberen Kante der Patientenliege (120) angeordnet ist.

4. Verfahren nach einem der vorhergehenden Ansprüche, wobei die BO-Referenzdaten entlang der ersten Raumrichtungen nur für einen vordefinierten Bereich bereitgestellt werden, wobei der vordefinierte Bereich vorzugsweise zum Bereich der Höhenverstellbarkeit der Patientenliege (120) korrespondiert.

5. Verfahren nach Anspruch 4, wobei der vordefinierte Bereich in einem auf einen B0-Feldmagneten (110) ausgerichteten Koordinatensystem (DCS-Koordinatensystem) eine Y-Koordinatenachse zwischen -700 bis 0 mm aufweist.

6. Verfahren nach einem der vorhergehenden Ansprüche, wobei die BO-Referenzdaten entlang der ersten Raumrichtung in Rasterpunkten mit einer Auflösung zwischen 0,1 und 10 mm, vorzugsweise zwischen 0,5 und 2 mm, besonders bevorzugt zwischen 0,7 und 1,5 mm und noch weiter bevorzugt mit einer Auflösung von 1 mm bereitgestellt werden.

7. Verfahren nach einem der vorhergehenden Ansprüche, wobei Streufeldinformationen zwischen zwei benachbarten Rasterpunkten durch Interpolation bereitgestellt werden, vorzugsweise durch eine lineare Interpolation oder eine Spline-Interpolation.

8. Verfahren nach einem der vorhergehenden Ansprüche, wobei die Positionsinformation des Objekts (120) in der ersten Raumrichtung durch Vergleich des Messwerts mit den B0-Referenzdaten ermittelt wird, wobei
die Positionsinformationen in einem ersten Bereich durch Vergleich eines Betrages der Messwertkomponenten in den drei Raumrichtungen mit den BO-Referenzdaten ermittelt wird;
die Positionsinformationen in einem zweiten Bereich durch Vergleich einer Messwertkomponente in der dritten Raumrichtung; und
die Positionsinformationen in einem dritten Bereich durch Vergleich einer Messwertkomponente in der ersten Raumrichtung mit den BO-Referenzdaten ermittelt wird.

9. Verfahren nach einem der vorhergehenden Ansprüche, wobei der dreidimensionale Magnetfeldstärkensensor (125, 126) derart am Objekt (120) angeordnet ist, dass die Achsen des dreidimensionalen Magnetfeldstärkensensors (120) kollinear zu drei X-Y-Z-Koordinatenachsen des magnetischen Streufelds ausgerichtet sind.

10. Verfahren nach einem der vorhergehenden Ansprüche, wobei das Objekt (120) weiterhin zumindest ein Speichermittel umfasst, in der zumindest die BO-Referenzdaten entlang der ersten Raumrichtung gespeichert werden.

11. Verfahren nach einem der vorhergehenden Ansprüche, wobei das Objekt (120) weiterhin zumindest ein Rechenmittel umfasst, dass eingerichtet ist, um die Positionsinformation des Objekts (120) bereitzustellen.

12. Verfahren nach einem der vorhergehenden Ansprüche, weiterhin aufweisend:
Bereitstellen eines Korrekturfaktors basierend auf einer Resonanzfrequenz der das magnetisches Streufeld erzeugenden Vorrichtung (100), vorzugsweise der Magnetresonanztomographen (100); und
Anpassen der BO-Referenzdaten des magnetischen Streufelds basierend auf dem Korrekturfaktor.

13. Verfahren nach einem der vorhergehenden Ansprüche, weiterhin aufweisend:
Bereitstellen von Steuerdaten für eine Bewegungseinrichtung, die eingerichtet ist, zumindest ein Teil des Objekts (120) zu bewegen, wobei die Steuerdaten auf der bereitgestellten Positionsinformation des Objekts (120) in der ersten Raumrichtung basieren.

14. System zur Bereitstellung einer Positionsinformation eines Objekts (120) mit einem dreidimensionalen Magnetfeldstärkensensor (125, 126) im Umfeld einer ein magnetisches Streufeld erzeugenden Vorrichtung (100), umfassend:
eine erste Schnittstelle, eingerichtet zum Empfangen von BO-Referenzdaten des magnetischen Streufelds zumindest entlang einer erster Raumrichtung, wobei die erste Raumrichtung orthogonal zu einer zweiten Raumrichtung und einer dritten Raumrichtung vorgesehen ist, und wobei die BO-Referenzdaten entlang der ersten Raumrichtung an einer vordefinierten Position in der zweiten Raumrichtung und der dritten Raumrichtung bereitgestellt ist;
eine zweite Schnittstelle, eingerichtet zum Empfangen eines Messwerts des Magnetfeldstärkensensors (125, 126) an der vordefinierten Position;
eine Rechnereinheit, die mit den Schnittstellen verbunden ist und dazu konfiguriert ist, das Verfahren nach einem der Ansprüche 1 bis 13 auszuführen.

15. Verwendung einer in einer ersten Raumrichtung höhenverstellbar eingerichteten Patientenliege (120) mit zumindest einem dreidimensionalen Magnetfeldstärkensensor (125, 126) in einem Verfahren nach einem der Ansprüche 1 bis 13.
